Europäisches Patentamt

European Patent Office

Office européen des brevets

(11) Publication number: **0 142 167**
**A2**

# (12) EUROPEAN PATENT APPLICATION

(21) Application number: 84113700.3

(22) Date of filing: 13.11.84

(51) Int. Cl.⁴: **H 03 K 19/094**

(30) Priority: 14.11.83 JP 213783/83

(43) Date of publication of application:
22.05.85 Bulletin 85/21

(84) Designated Contracting States:
DE FR GB NL

(71) Applicant: NEC CORPORATION
33-1, Shiba 5-chome, Minato-ku
Tokyo 108(JP)

(71) Applicant: Nippon Telegraph and Telephone Public
Corporation
1-6 Uchisaiwai-cho 1-chome Chiyoda-ku
Tokyo 100(JP)

(72) Inventor: Mitami, Masataka c/o NEC Corporation
33-1 Shiba 5-chome Minato-ku
Tokyo(JP)

(72) Inventor: Matsuura, Takashi c/o NEC Corporation
33-1 Shiba 5-chome Mianto-ku
Tokyo(JP)

(72) Inventor: Habuka, Tatsuji
2-1-3, Hayashi
Yokosuka-shi Kanagawa(JP)

(72) Inventor: Kimura, Tadakatsu
1048-305, Kawaraguchi
Ebina-shi Kanagawa(JP)

(74) Representative: Vossius Vossius Tauchner Heunemann
Rauh
Siebertstrasse 4 P.O. Box 86 07 67
D-8000 München 86(DE)

(54) Level shifting circuit.

(57) A level shifting circuit for level shifting an input signal so
as to correspond with the operating level of a logic circuit of
the next stage. The level shifting circuit comprises a first
CMOS inverting amplifier circuit (A₁) without provision of a
feedback loop and a second CMOS inverting amplifier circuit
(A₂) whose output is coupled to the input through a low impe-
dance element (L1), either the input or the output of the sec-
ond amplifier circuit (A₂) being connected to the input of the
first amplifier circuit (A₁). The second amplifier circuit (A₂)
functions as an auto-bias circuit with respect to the first amp-
lifier circuit (A₁). The level shifting circuit thus formed makes it
possible to remarkably reduce power consumption and occu-
pation area when configured as an integrated circuit.

F I G.3

# LEVEL SHIFTING CIRCUIT

The present invention relates to a level shifting circuit for shifting a digital input signal voltage of a low level to a digital signal voltage suitable for an operating voltage for a logic circuit. Specifically, the present invention relates to an improvement in a level shifting circuit including an auto-bias circuit using a CMOS (complementary Metal Oxide Semiconductor) inverting amplifier circuit.

In driving a logic circuit, when a voltage level of an input signal is low, it is necessary to level shift the input signal so as to correspond with the operating voltage of the logic circuit. For instance, when driving a logic circuit which operates at a so-called TTL level of 5V amplitude, if an input signal for driving the logic circuit has an amplitude of 1V, it is required to use a level shifting circuit capable of level shifting the input signal of 1V to the voltage of 5V TTL level.

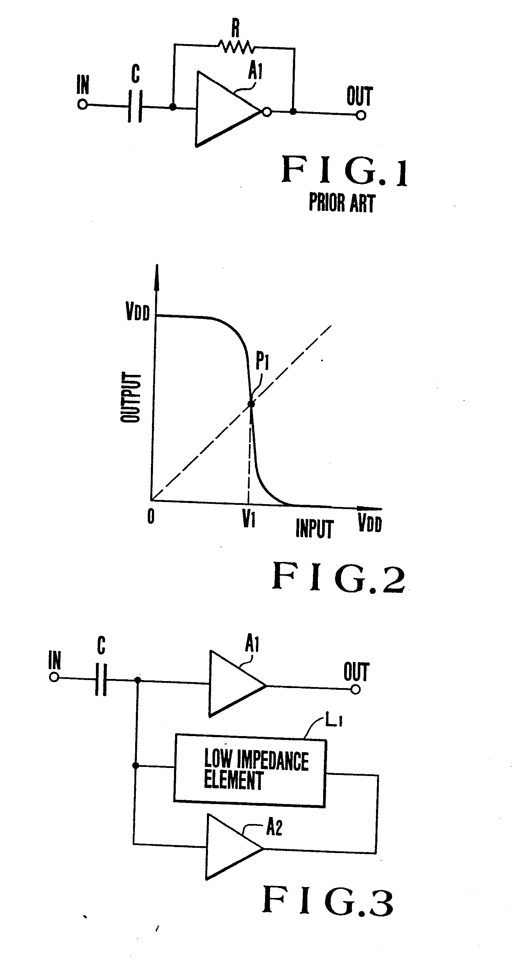

As a level shifting circuit of this type, there has hitherto been known an auto-bias circuit utilizing a CMOS inverting amplifier circuit. Fig. 1 is a circuit diagram showing an example of the conventional level shifting circuit. This circuit comprises input and output terminals IN and OUT, a CMOS inverting amplifier circuit $A_1$, an AC coupling capacitor C connected between the input terminal IN and the input of the CMOS inverting amplifier circuit $A_1$, and a negative feedback resistor R connected between the output and the input of the CMOS inverting amplifier circuit $A_1$. With this circuit configuration, the input bias voltage of the CMOS inverting amplifier circuit $A_1$ is automatically set to an optimal operational point. Namely, the input/output operating characteristic of the CMOS inverting amplifier circuit $A_1$ is such that the output voltage abruptly varies when the input voltage is in the vicinity of $V_1$ as shown in Fig. 2. Accordingly, when an input signal is applied under the application of the negative feedback by the resistor R, the CMOS inverting amplifier circuit $A_1$ automatically becomes stable at a point P1 of the maximum amplification factor, as indicated in Fig. 2. Accordingly, if the input is biased to this voltage $V_1$, an input signal having a small amplitude can be level shifted to an output signal swingable between zero volt level and a power supply voltage level.

Such conventional level shifting circuit is excellent, having a small number of elements and therefore has been widely used. However, the drawbacks which can not be avoided in forming such a conventional level shifting circuit as an integrated circuit are as follows:

(1)     To increase gain of this circuit, the resistor R must have a large resistance. However, the large-resistance resistor occupies a large area on an intergrated circuit ; and

(2) Under the application of the negative feedback by the resistor R as shown in Fig. 1, the output impedance at the output terminal OUT is undesirably decreased below the input impedance of a logic circuit of the next stage connected to the output terminal OUT, so that drive power for the COMS inverting amplifier circuit $A_1$ increases.

## Summary of the Invention

Accordingly, an object of the present invention is to provide a level shifting circuit suitable for an integrated circuit which can be minimized in area and power consumption.

In a level shifting circuit according to the present invention, a resistor R for negative feedback, which is connected between the input and the output of a CMOS inverting amplifier circuit $A_1$ in the prior art, is removed thereby to increase the gain of the CMOS inverting amplifier circuit $A_1$ and to raise the output impedance thereof. A second CMOS inverting amplifier circuit $A_2$ whose input/output voltage characteristic is substantially identical to that of the first CMOS inverting amplifier circuit $A_1$ is connected to the input of the CMOS inverting amplifier circuit $A_1$. The input and the output of the second CMOS inverting amplifier circuit $A_2$ are coupled through a low impedance means Ll, thus providing an optimum automatic bias voltage from the second CMOS inverting amplifier circuit $A_2$ to the first CMOS inverting amplifier circuit $A_1$. For instance, the low impedance means Ll may comprise a conductive wire through which the output and the input of the second CMOS inverting amplifier circuit are coupled to each other.

Brief Description of the Drawings

The features and advantages of a level setting circuit according to the present invention will become more apparent from the following description taken in conjuncton with the accompanying drawings, in which:

Fig. 1 is circuit diagram showing a conventional level shifting circuit;

Fig. 2 shows an input/output voltage characteristic curve in a CMOS inverting amplifier circuit;

Fig. 3 is a schematic circuit diagram showing a level shifting circuit according to an embodiment of the present invention; and

Fig. 4 is a circuit diagram showing a level shifting circuit for implementation of the circuit shown in Fig. 3.

Description of the Preferred Embodiments

A preferred embodiment of a level setting circuit according to the present invention will be described with reference to the attached drawings.

Referring now to Fig. 3, a level shifting circuit comprises an input terminal IN for a digital small input signal, an output terminal OUT which is connected to a logic circuit (not shwon) of the next stage, a first CMOS inverting amplifier circuit $A_1$ without a feedback loop connected between the input and output terminals IN and OUT wherein an AC coupling capacitor C is conncted between the input terminal IN and the input of the first CMOS inverting amplifier circuit $A_1$. The level shifting circuit of the invention further comprises a second CMOS inverting amplifier circuit $A_2$ whose characteristic is substantially identical to that of the first CMOS inverting amplifier $A_1$ wherein the output and the input of the second CMOS inverting amplifier circuit $A_2$ are coupled to each other through a low impedance means Ll and the junction of the output and the input thereof is directly connected to the input of the first CMOS inverting amplifier circuit $A_1$. A digital signal input having a small voltage level is fed to the input terminal IN. The signal appearing at the input terminal IN is fed to the input of the CMOS inverting amplifier circuit $A_1$ through the capacitor C.

As stated above, the present invention is characterized in that the second CMOS inverting amplifier circuit $A_2$ is newly provided without providing a resistor for negative feedback in the CMOS inverting amplifier circuit $A_1$, in that the output and the input of the second CMOS inverting amplifier circuit $A_2$ are coupled to each other, and in that the node or junction of the output and the input thereof is directly connected to the input of the first CMOS inverting amplifier circuit $A_1$.

The novel circuit configuration allows the gain of the first CMOS inverting amplifier circuit $A_1$ to be large and the output impedance to be high. However, when using only the first inverting CMOS amplifier circuit $A_1$ without feedback network, the above-mentioned auto-bias function will be lost and therefor is unable to perform an optimum operation unless a bias voltage is externally provided to the input of the circuit $A_1$. In the present invention, this bias voltage is given by the second CMOS inverting amplifier circuit $A_2$. Namely, as previously mentioned, the second CMOS inverting amplifier circuit $A_2$ has the same input/output voltage characteristic as that of the first CMOS inverting amplifier circuit $A_1$. Accordingly, with the output and the input of the second CMOS inverting amplifier circuit $A_2$ coupled to provide a large negative feedback, when an input signal is supplied to this level shifting circuit $A_2$, the bias voltage is set to a value $V_1$ at which the input/output voltage characteristic curve abruptly changes to the maximum degree as shown in Fig. 2. The voltage $V_1$ thus determined is supplied to the input of the CMOS inverting amplifier circuit $A_1$. Thus, the CMOS inverting amplifier circuit $A_1$ will become operative at an optimum bias voltage.

In general, when a plurality of CMOS inverting amplifier circuits are formed on the same integrated circuit, respective input/output voltage characteristics are substantially equal to each other regardless of their geometry. For this reason, it is automatically possible to form e.g. two inverting amplifier circuits whose charactristics may be identical to each other, without requiring a particular process for equalizing their input/output voltage charactristics.

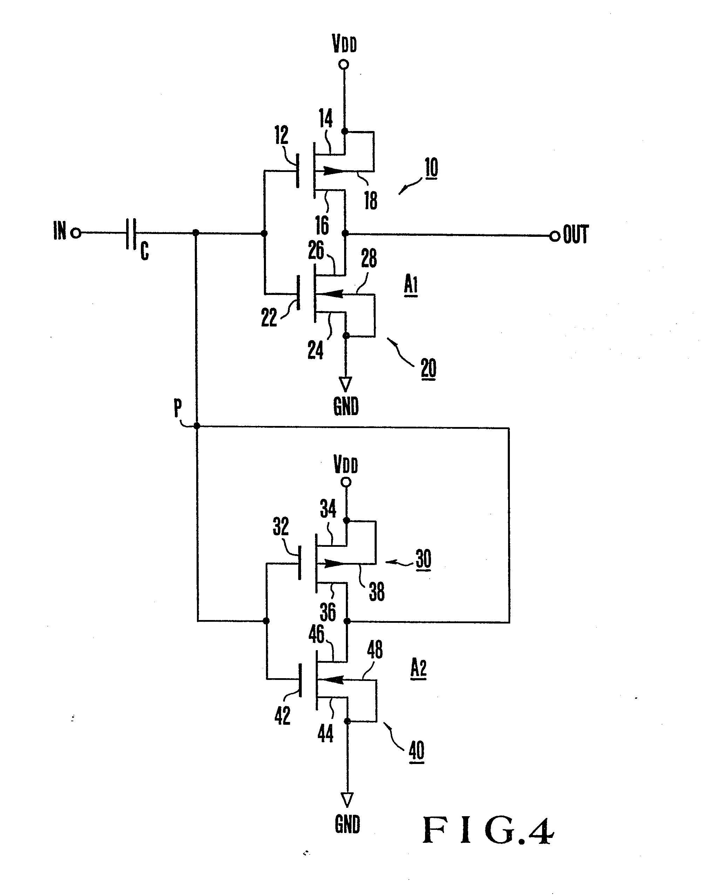

Fig. 4 is a detailed circuit diagram showing an embodiment of a level shifting circuit based on the circuit construction shown in Fig. 3. Referring to Fig. 4, the first CMOS inverting amplifier circuit $A_1$ comprises a complementary p-channel MOS field effect tansistor (FET) 10 and an n-channel MOS FET 20. A gate 12 of the p-channel MOS FET 10 and a gate 22 of the n-channel MOS FET 20 are connected in common at the side of the input of the inverting amplifier circuit $A_1$. A drain 16 of the p-channel MOS FET 10 and a drain 26 of the n-channel MOS FET 20 are connected in common at the side of the output of the inverting amplifier circuit $A_1$. A source 14 and an auxiliary gate 18 of the p-channel MOS FET 10 are connected to a terminal $V_{DD}$ of a DC power supply. A source 24 and an auxiliary gate 28 of the n-channel MOS FET 20 are connected to a common potential point or ground GND. Similarly, the second CMOS inverting amplifier circuit $A_2$ comprises a complementary p-channel MOS FET 30 and an n-channel MOS FET 40. A gate 32 of the p-channel MOS FET 30 and a gate 42 of the n-channel MOS FET 40 are connected in common at the side of the input of the inverting amplifier circuit $A_2$. A drain 36 of the p-channel MOS FET 30 and a drain 46 of the n-channel MOS FET 40 are connected in common at the side of the output of the inverting amplifier circuit $A_2$. A source 34 and an auxiliary gate 38 of the p-channel MOS FET 30 are connected to the terminal $V_{DD}$ of the DC power supply. A a source 44 and an auxiliary gate 48 of the n-channel MOS FET 40 are connected to ground GND. The second CMOS inverting amplifier circuit $A_2$ are configured so that its output and input are coupled at a node P through a low impedance means comprised of a conductive wire to provide large negative feedback from the output to the input. Similar to the circuit shown in Fig. 3, the node P is connected to the input of the first CMOS inverting amplifier circuit $A_1$. As seen from Fig. 4, the level shifting circuit shown is not provided with a resistor and therefore a process for forming a resistor is not required in the manufacture of the integrated circuit.

The level shifting circuit thus configured can level shift an input digital signal, e.g. 1V coming into the input terminal IN so that its output voltage becomes 5V equal to the power supply voltage.

As stated above, the second CMOS inverting amplifier circuit $A_2$ functions as a circuit for providing a DC bias voltage to the first CMOS inverting amplifier circuit $A_1$. Accordingly, the circuit $A_2$ is satisfied with greatly reduced output power and therefore the second CMOS inverting amplifier circuit $A_2$ can be constituted with a CMOS inverting amplifier circuit whose driving power is very small. Accordingly, the second CMOS inverting amplifier circuit $A_2$ can be formed in an integrated circuit within an area which is much smaller than the area occupied by the resistor R required for the prior art circuit. Further, the second CMOS inverting amplifier circuit $A_2$ can be fabricated simultaneously with the first CMOS inverting amplifier circuit $A_1$ on the integrated circuit through the same fabrication process. This is advantageous as compared to the case where the resistor R is formed on the integrated circuit as in the prior art.

Further, since the CMOS inverting amplifier circuit $A_1$ does not require a negative feedback loop, its voltage gain becomes large and the output impedance becomes high. This results in good impedance matching with a logic circuit of the next stage connected to the output terminal OUT and minimization of drive power. Namely, this means that it is possible to realize the first CMOS inverting amplifier circuit $A_1$ having functions identical to the prior art circuit using a CMOS inverting amplifier circuit smaller than the prior art circuit. For the same output, the total power consumption resulting from the two CMOS inverting amplifier circuits $A_1$ and $A_2$ can be much smaller than the power consumption of the prior art CMOS inverting amplifier circuit $A_1$ alone.

In the above-mentioned embodiment, the CMOS inverting amplifier circuit comprising the combination of the p-channel MOS transistor and the n-channel MOS transistor has been described. However, such types of CMOS circuits are taken only for illustration purpose and therefore the present invention can be also practiced using other types of CMOS circuits.

Further, in the above-mentioned embodiment, the input and the output of the second CMOS inverting amplifier circuit have been directly connected, but in stead of this, the present invention can be practiced by connecting the output with the input through an element having low impedance. In this instance, either the input or the output of the second CMOS inverting amplifier circuit may be coupled to the input of the first CMOS inverting amplifer circuit.

As described above, the level shifting circuit according to the present invention is configured wherein negative feedback is not provided to the first CMOS inverting amplifier circuit for amplifying a signal, and an auto-bias voltage produced from the second CMOS inverting amplifier circuit is supplied to the input of the first CMOS inverting amplifier circuit. Thus, the present invention can provide a level shifting circuit in which the power consumption and the area occupation in the integrated circuit can be reduced as compared to those of the prior art circuit.

Claims

1.    A level shifting circuit comprising a first CMOS inverting amplifier circuit (Al) to level shift an input signal which is inputted through an AC coupling capacitor (C) so as to correspond with the operating level of a logic circuit of the next stage,

characterized in that there is provided a second CMOS inverting amplifier circuit (A2) whose input-output voltage characteristic is substantially identical to that of said first CMOS inverting amplifier circuit (Al), that said second CMOS inverting amplifier circuit (A2) have an output and an input which are coupled to each other through low impedance means (Ll), and that either said input or output of said second CMOS inverting amplifier circuit (A2) is connected to said input of said first CMOS inverting amplifier circuit (Al).

2.    A level shifting circuit according to claim 1, wherein said low impedance means comprises an electrically conductive conductor through which said output and second input of said second CMOS inverting amplifier circuit are coupled.

3.    A level shifting circuit according to claim 1 or 2, wherein said first and second CMOS inverting amplifier circuits are integrally formed into an integrated circuit.

4.	A level shifting circuit according to any of claims 1 to 3 wherein each of said first and second CMOS inverting amplifier circuits comprises a pair of p-channel and n-channel MOS transistors complementarily connected to each other.

IN C R A1 OUT

# FIG.1
**PRIOR ART**

VDD

OUTPUT

P1

0 V1 INPUT VDD

# FIG.2

IN C A1 OUT

L1

LOW IMPEDANCE ELEMENT

A2

# FIG.3

F I G.4